# EUROPÄISCHE PATENTANMELDUNG

(11) **EP 1 724 834 A1**
(43) Veröffentlichungstag der Anmeldung: **22.11.2006**
(21) Anmeldenummer: 06008981.0
(22) Anmeldetag: 29.04.2006
(51) Int. Cl.: H01L 25/075, H01L 33/00

(54) **Vorrichtung zur Erzeugung von Strahlung sowie Nachtsichtgerät mit einer solchen Vorrichtung**

(30) Priorität: 16.05.2005 DE 102005023210
(71) Anmelder: Noctron Holding S.A., 8140 Bridel (LU)
(72) Erfinder: Diamantidis, Georg, 56307 Dernbach (DE)
(74) Vertreter: Ostertag, Reinhard

(57) **Zusammenfassung**

Bei einer Vorrichtung (10) zur Erzeugung von Strahlung mit mehreren in einer Ebene angeordneten LEDs (20) sind die LEDs (20) hinter einer gemeinsamen Sammeloptik (24) angeordnet.

## Beschreibung

Die Erfindung betrifft eine Vorrichtung zur Erzeugung von Strahlung mit mehreren in einer Ebene angeordneten LEDs.

Außerdem betrifft die Erfindung ein Nachtsichtgerät mit einer Kamera.

Derartige Vorrichtungen zur Erzeugung von Strahlung sind bekannt und werden bereits in Taschenlampen oder auch Nachtsichtgeräten eingesetzt. Dabei hat sich die Verwendung von LEDs etabliert.

Schwierigkeiten bereitet es bei derartigen Vorrichtungen, für bestimmte Anwendungsgebiete einen ausreichend gebündelten Lichtstrahl mit hinreichender Intensität zu erzeugen.

Dieses Problem stellt sich auch bei Nachtsichtgeräten, deren LEDs normalerweise Strahlung im Infrarotbereich emittieren.

Aufgabe der vorliegenden Erfindung ist es, eine Vorrichtung zur Erzeugung von Strahlung der Eingangs genannten Art zu schaffen, welche eine hohe Intensität bei geringen Abmessungen gewährleistet.

Dies wird bei einer Vorrichtung der eingangs angesprochenen Art dadurch erreicht, daß die LEDs hinter einer gemeinsamen Sammeloptik angeordnet sind.

Durch diese Anordnung der LEDs hinter einer Sammeloptik wird erreicht, daß die aus den LEDs austretende Strahlung zu einem gemeinsamen Strahl gebündelt wird.

Es ist vorteilhaft, wenn die Sammeloptik wenigstens eine plan-konvexe, vorzugsweise im wesentlichen halbkugelförmige Linse umfaßt, welche derart angeordnet ist, daß die LEDs bei ihrer planen Linsenfläche angeordnet sind.

In der Praxis hat sich gezeigt, dass eine derartige Linse mit einem Durchmesser von ca. 5.6 mm gute Ergebnisse liefert. Ein um bis zu 200 % besserer Wirkungsgrad wird mit einer Linse mit ca. 7,8 mm Durchmesser erzielt.

Eine alternative günstige Ausgestaltung der Sammeloptik besteht darin, wenn diese eine der Anzahl der LEDs entsprechende Zahl von plan-konvexen Linsen umfaßt.

Für besondere Anwendungen, wie bei Nachtsichtgeräten, ist es vorteilhaft, wenn wenigstens ein Teil der LEDs Infrarot-Strahlung emittiert, wobei es dann günstig ist, wenn die LEDs Strahlung mit einer Wellenlänge von etwa 850 nm emittieren.

Je nach Anwendung kann es wünschenswert sein, daß wenigstens ein Teil der LEDs Strahlung im sichtbaren Wellenlängenbereich emittiert, wobei es für ein gutes Ausleuchten von Objekten insbesondere von Vorteil ist, wenn die LEDs Weißlicht emittieren.

Je nach Betriebsanforderungen kann vorzugsweise vorgesehen sein, daß alle verwendeten LEDs nur Infrarot-Strahlung bzw. nur Strahlung im sichtbaren Wellenlängenbereich emittieren. sichtgerät zur Verfügung zu stellen, welches gut gebündelte LED-Strahlung hoher Intensität bei geringem Platzbedarf der Strahlungsquelle bietet.

Diese Aufgabe wird durch ein eingangs genanntes Nachtsichtgerät gelöst, welches eine oben erläuterte Vorrichtung zur Erzeugung von Strahlung umfaßt.

Nachstehend werden Ausführungsbeispiele der Erfindung anhand der beigefügten Zeichnung erläutert. In dieser zeigen:
- Figur 1: eine Aufsicht auf eine Strahlungsquelle;
- Figur 2: einen Schnitt der Strahlungsquelle nach Figur 1 entlang der dortigen Schnittlinie II-II;
- Figur 3: einen der Figur 2 entsprechenden Schnitt eines zweiten Ausführungsbeispiels der Strahlungsquelle mit einer alternativen Sammeloptik;
- Figur 4: schematisch ein Nachtsichtgerät mit einer Strahlungsquelle nach den Figuren 1 bis 3; und
- Figur 5: eine ähnliche Ansicht wie Figur 2, in welcher eine weiter abgewandelte Stralungsquelle gezeigt ist.

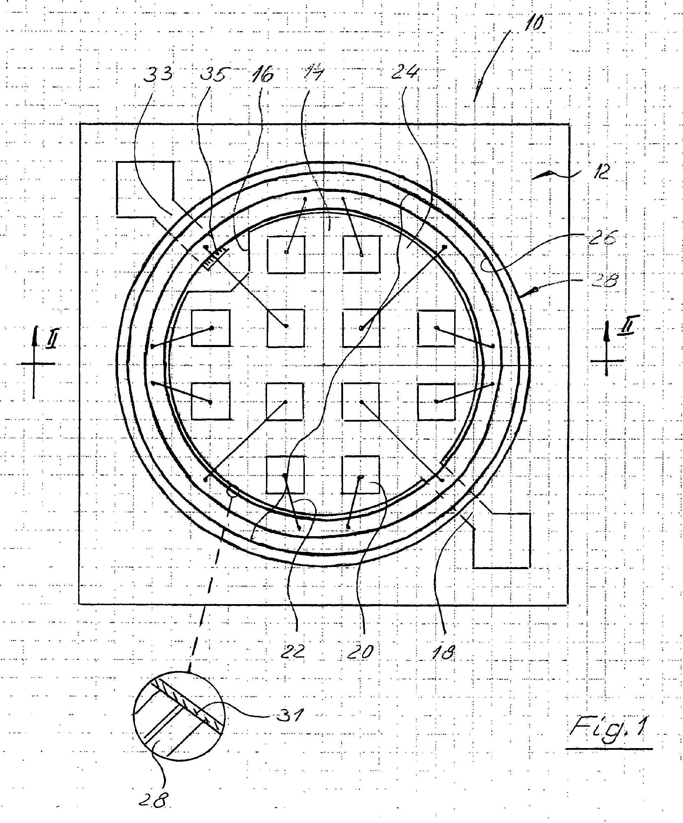

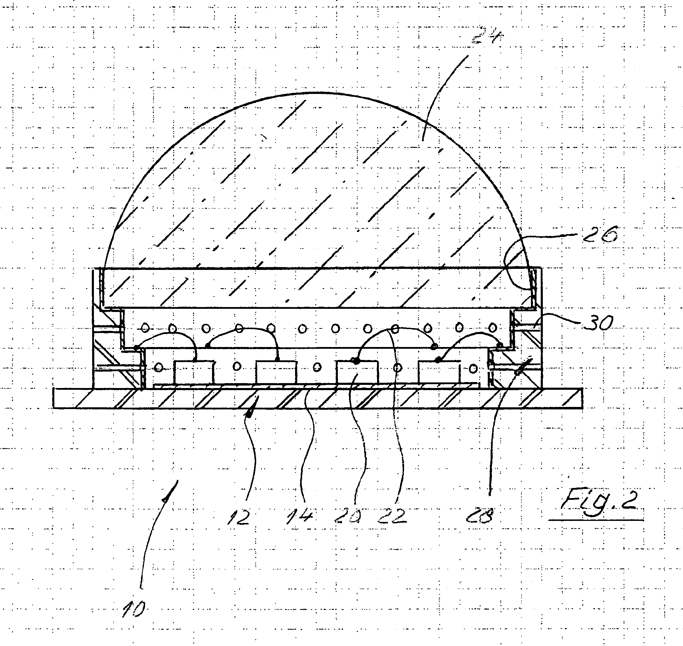

Die Figuren 1 und 2 zeigen eine Strahlungsquelle 10.
Ein Platine 12 trägt eine im wesentliche kreisförmige Leiterfläche 14. Letztere ist an zwei gegenüberliegenden Stellen mit einer Ausnehmnung 16 bzw. einem radialen Anschlußsteg 18 versehen.

Auf der Leiterfläche 14 sind die Kathoden einzelner LEDs 20 angelötet. Die Anoden der LEDs 20 sind über Anschlußdrähte 22 mit Spannung beaufschlagbar, wie noch genauer beschrieben wird.

Über den LEDs 20 ist eine Sammeloptik 24 angeordnet, die als plankonvexe im wesentlichen halbkugelige Sammellinse gezeigt ist, die mit ihrem Rand in einer stirnseitigen Gegenbohrung 26 eines Distanzringes 28 aus Kunststoff einsitzt. Der Distanzring 28 ist mit seiner von der Gegenbohrung 26 abliegenden Stirnfläche auf der Platine 14 befestigt. Die Sammellinse ist (z.B. mittels eines geeigneten Klebstoffes) mit dem Distanzring 28 starr verbunden.

Um die durch die LEDs erzeugte Strahlungswärme abzuführen, weist der Distanzring 28 radiale Lüftungsbohrungen 30 auf, die unterhalb der Gegenbohrung 26 parallel zur Platine 14 verlaufen.

Eine andere Möglichkeit, eine ausreichende Wärmeabfuhr zu gewährleisten, besteht darin, daß die Sammellinse nicht in einem umlaufenden Distanzring einsitzt, sondern vielmehr in voneinander in Umfangsrichtung beabstandet angeordneten Ringsegementen befestigt ist. Der Wärmeaustausch erfolgt dann über die Zwischenräume zwischen den einzelnen Ringsegmenten.

Der Distanzring 28 ist auf seiner abgestuften Innenfläche mit einer Leiterfläche 31 versehen, die bis zur unteren Stirnfläche des Distanzringes 28 reicht, letztere aber vollständig frei läßt. Die Platine 14 trägt von der Ausnehmung 16 beabstandet einen zweiten radialen Anschlußsteg 33, der durch eine Lötstelle 35 mit der Leiterfläche 31 verbunden ist.

Die von den LEDs 20 abliegenden Enden der Anschlußdrähte 22 sind mit der Leiterfläche 31 im Bereich des Bodens der Gegenbohrung 26 elektrisch verbunden.

Damit leuchten die LEDs 20 auf, wenn an die Anschlußstege 18 und 33 eine Spannung angelegt wird.

Das Material für die Leiterflächen 14 und 31 ist aus einem Metall gewählt, welches neben guten elektrischen Eigenschaften und guter Lötbarkeit auch eine gute Reflexion für das von den LEDs 20 abgegebene Licht aufweist, z.B. Silber. Auf diese Weise ist das Innere des durch die Platine 14 und den Distanzrahmen 28 gebildeten topfförmigen Raumes verspiegelt und reflektiert von den LEDs 20 her auffallendes Licht.

Je nachdem, ob die Licht abgebende Seite der LEDs näher bei der Anode oder der Kathode liegt, wird man diese Seite der LEDs nach vorne weisend vorsehen und über die Anschlußdrähte 22 mit Spannung versorgen, währen die andere Seite der LEDs mit der Leiterfläche 14 verlötet wird.

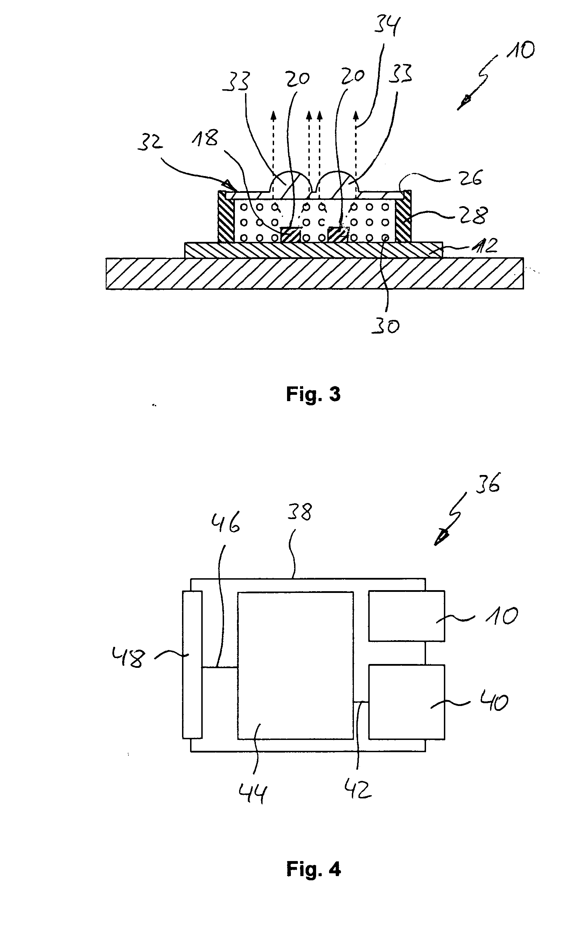

Bei dem in Figur 3 gezeigten Ausführungsbeispiel der Strahlungsquelle 10 ist bei ansonsten unveränderten Komponenten eine alternative Sammeloptik 32 vorgesehen. Diese umfaßt eine der Anzahl der LEDs entsprechende Zahl von kleinen plan-konvexen Linsen 33, von denen jede jeweils über einer LED 20 angeordnet ist und die zu einer gemeinsamen Sammeloptik zusammengefasst sind. Die Sammeloptik 32 kann aus Kunststoff gefertigt und einstückig gespritzt sein.

Die verwendeten LEDs 20 sind je nach Anwendungsbereich und auswählbar und können beispielsweise Infrarot-Strahlung mit einer Wellenlänge von etwa 850 nm und/oder Licht im sichtbaren Wellenlängenbereich, vorzugsweise Weißlicht, emittieren. Auch alle anderen Spektralbereiche können je nach Auswahl der LEDs 20 zum Einsatz kommen.

Darüber hinaus ist eine Kombination unterschiedliche Strahlung emittierender LEDs 20 vorstellbar, z.B. LEDs 20, welche Infrarot-Strahlung emittieren, zusammen mit Weißlicht emittierenden LEDs 20.

Bei den in den Figuren 1 bis 3 gezeigten Ausführungsbeispielen sind die LEDs 20 in einer Matrix angeordnet, welche einen kreisförmigen Distanzring gut ausfüllt. Abhängig von dem durch den Durchmesser der Sammelloptik 24 bzw. 32 und die Geometrie des Distanzringes 28 festgelegten zur Verfügung stehenden Raum sind jedoch auch beliebig andere Anordnungen vorstellbar, darunter auch solche mit konzentrischen Kreisen und konzentrishcen Polygonen.

Auch kann der Distanzring 26 in Aufsicht gesehen rechteckig oder polygonal sein.

Vorzugsweise bildet aber bei kreisförmigem Ditanzring 28 die Randkontur des Rasters, in welchem die LEDs angeordnet sind, ein Polygon, welches in den Kreis eingeschrieben ist, der durch den inneren Rand des Distanzringes 28 vorgegeben ist. Dabei sind die LEDs so dicht gepackt, wie dies im Hinblick auf ihre Abmessung und die Erfordernisse der Wärmeabführung möglich ist.

Durch die Sammeloptiken 24, 32 wird nun erreicht, daß auch ein Teil der sonst zur Seite austretende Strahlung der LEDs 20 in eine Hauptstrahlrichtung, die in den Figuren 2 und 3 durch gestrichelte Pfeile 34 angedeutet ist, gerichtet wird.

Die durch die Leiterflächen 14 und 31 gebildete Verspiegelung dient ebenfalls der Nutzbarmachung in seitlicher Richtung aus den LEDs austretenden Lichtes.

Die oben erläuterte Strahlungsquelle 10 eignet sich zum Einsatz in einem Nachtsichtgerät ansonsten üblicher Bauart, da die Strahlungsquelle 10 bei Erreichen einer in Relation der Anzahl der verwendeten LEDs 20 großen Strahlungsleistung baulich klein gehalten werden kann.

Ein solches Nachtsichtgerät 36 ist schematisch in Figur 4 gezeigt, wobei dort vorzugsweise Infrarot-Strahlung emittierende LEDs 20 zum Einsatz kommen.

Das Nachtsichtgerät 36 umfaßt ein Gehäuse 38, in dessen vorderer Wand eine Strahlungsquelle 10 und eine Kamera 40 zum Erfassen von einfallender Strahlung vorgesehen sind. Diese kann z. B. einen CCD-Sensor umfassen.

Dieser arbeitet über eine Leitung 42 mit einer Bildverarbeitungseinrichtung 44 zusammen, welche die bearbeiteten Bildsignale über eine Leitung 46 für eine Anzeige 48, wie ein LCD-Display, bereitstellt. Dort kann das von dem Nachtsichtgerät 36 empfangene Bild von einem Benutzer betrachtet werden.

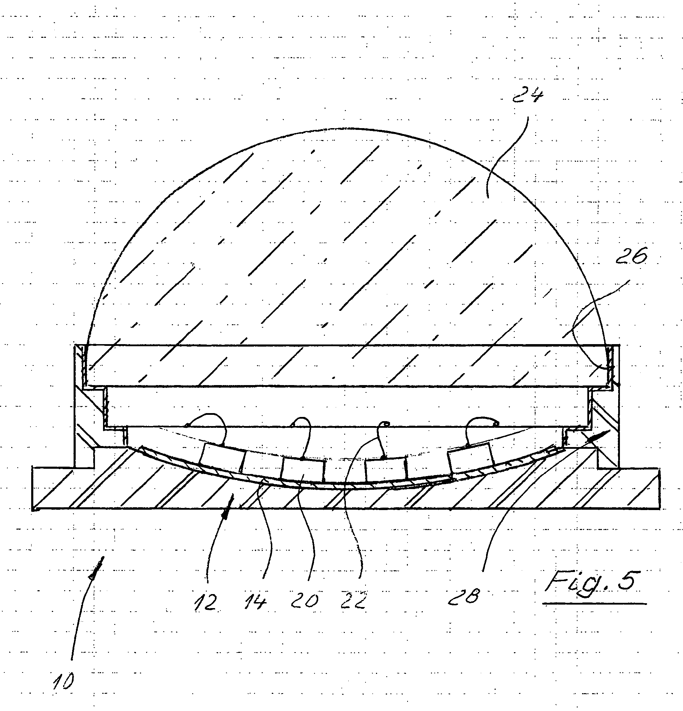

Das Ausführungsbeispiel nach Figur 5 entspricht weitgehend demjenigen nach Figuren 1 und 2. Entsprechende Komponenten sind wieder mit den selben Bezugszeichen versehen und brauchen nicht nochmals beschrieben zu werden.

Bei der Strahlngsquelle 10 nach Figur 5 ist die Platine 14 durch ein dickeres Spritzteil aus isolierendem Kunststoff gebildet, dessen Oberseite im Bereich der Leiterfläche 14 sphärisch gekrümmt ist, so daß die Platine 14 als sammelnder Hohlspiegel wirkt.

In weiterer Abwandlung kann die Oberseite der Platine 14 als Parabolspiegel oder als hyperbolischer Spiegel ausgebildet sein.

Auch kann man die Leiterfkäche 31 als die Leiterfläche 14 umgebende Ringfläche auf der Platine 14 vorsehen und ist dann frei in der Formgebung der Innenfläche des Distanzringes 28 und der Art seiner Verspiegelung.

Man kann dann die Innenfläche des Distanzringes 28 z.B. als im wesentlichen glatte Fortsetzung der gewölbten Oberfläche der Platine 14 wählen, so daß beide Verspiegelungen zusammen einen größeren Anschnitt eines rotationssymmetrischen Spiegels bilden, z.B. eines Rotationsellipsoides.

## Patentansprüche

1. Vorrichtung zur Erzeugung von Strahlung mit mehreren in einer Ebene angeordneten LEDs (20), **dadurch gekennzeichnet, daß** die LEDs (20) hinter einer gemeinsamen Sammeloptik (24; 32) angeordnet sind.

2. Vorrichtung nach Anspruch 1, **dadurch gekennzeichnet, daß** die Sammeloptik (24; 32) wenigstens eine plan-konvexe, vorzugsweise im wesentlichen halbkugelförmige Linse (25; 33) umfaßt und die LEDs (20) bei der planen Linsenfläche angeordnet sind.

3. Vorrichtung nach Anspruch 2, **dadurch gekennzeichnet, daß** die Sammeloptik (32) eine der Anzahl der LEDs entsprechende Zahl von Linsen (33) umfaßt.

4. Vorrichtung nach einem der Ansprüche 1 bis 3, **dadurch gekennzeichnet, daß** sie LEDs (20) umfaßt, die in konzentrischen Polygonen oder Kreisen oder in einer Matrix, welche in einen Kreis eingepaßt ist, angeordnet sind.

5. Vorrichtung nach einem der Ansprüche 1 bis 4, **dadurch gekennzeichnet, daß** wenigstens ein Teil der LEDs (20) Infrarot-Strahlung emittiert.

6. Vorrichtung nach Anspruch 5, **dadurch gekennzeichnet, daß** die Infrarot-Strahlung emittierenden LEDs (20) Strahlung mit einer Wellenlänge von etwa 850 nm emittieren.

7. Vorrichtung nach einem der Ansprüche 1 bis 6, **dadurch gekennzeichnet, daß** wenigstens ein Teil der LEDs (20) Strahlung im sichtbaren Wellenlängenbereich emittiert.

8. Vorrichtung nach Anspruch 7, **dadurch gekennzeichnet, daß** die Strahlung im sichtbaren Wellenlängenbereich emittierenden LEDs (20) Weißlicht emittieren.

9. Vorrichtung nach einem der Ansprüche 1 bis 8, **dadurch gekennzeichnet, daß** die Sammeloptik (24; 32) über eine Distanzrahmen (28) mit einer die LEDs (20) tragenden Platine (12) verbunden ist.

10. Vorrichtung nach Anspruch 8, **dadurch gekennzeichzeichnet, daß** die Innenseite des Distanzrahmens (28) eine Verspiegelung (31) aufweist.

11. Vorrichtung nach Anspruch 10, **dadurch gekennzeichnet, daß** die Verspiegelung (31) durch eine Leiterfläche gebildet ist, welche mit den einen Anschlüssen der LEDs (20) verbunden ist.

12. Vorrichtung nach Anspruch 9, 10 oder 11, **dadurch gekennzeichnet, daß** der Distanzrahmen (28) Lüftungsöffnungen (30) aufweist.

13. Vorrichtung nach einem der Ansprüche 1 bis 12, **dadurch gekennzeichnet, daß** eine die LEDs (20) tragende Platine (12) auf der den LEDs (20) zugewandten Seite eine Verspiegelung (14) trägt.

14. Vorrichtung nach Anspruch 13, **dadurch gekennzeichnet, daß** die Verspiegelung (14) durch eine Leiterfläche gebildet ist, welche mit den anderen Anschlüssen der LEDs (20) verbunden ist.

15. Nachtsichtgerät mit einer Kamera (40), **gekennzeichnet durch** eine Vorrichtung zur Erzeugung von Strahlung nach einem der Ansprüche 1 bis 14.
